# EUROPEAN PATENT APPLICATION

(11) **EP 2 626 919 A1**
(43) Date of publication of application: **14.08.2013**
(21) Application number: 12844655.6
(22) Date of filing: 30.08.2012
(51) Int. Cl.: H01L 33/64, H01L 33/00, H01L 23/367

(54) **METHOD OF MANUFACTURING HEAT SINK STRUCTURE FOR HIGH-POWER LED**

(30) Priority: 09.11.2011 CN 201110351439
(71) Applicant: Dongguan Kingsun Optoelectronic Co., Ltd, Guangdong 523565 (CN)
(72) Inventor: BI, Xiaofeng, Dongguan Guangdong 523565 (CN)
(74) Representative: Michalski Hüttermann & Partner Patentanwälte
(86) International application number: PCT/CN2012/080761
(87) International publication number: WO 2013/067840

(57) **Abstract**

A manufacturing process of a high-power LED radiating structure includes steps of: (1) preparing a PCB board, a heat conducting plate which is provided with a heat conducting pole on its one side and a heat dissipating plate; (2) providing in the PCB board a locating hole passing through both sides of the PCB board, welding a copper plate layer on one side of the PCB board, and welding an electrode weld pad on the other side of the PCB board, and then applying soldering paste on the surface of the copper plate layer; (3) inserting the heat conducting pole into the locating hole from one side of the PCB board which is provided with the copper plate layer, and welding the copper plate layer and the heat conducting plate through reflow soldering; (4) placing the assembled heat conducting plate and the PCB board acquired in step (3) on a stamping equipment, to adjust the height of the heat conducting pole; and (5) fixedly engaging the upper side of the heat dissipating plate with the other side of the heat conducting plate. The inventive process is simple, and the manufactured dissipating structure is advantageous for a simple construction and good heat conducting and dissipating effects.

## Description

### Field of the Invention

The invention relates to the field of heat dissipating equipments, and more particularly, to a manufacturing process of a high-power Light-Emitting Diode (LED) radiating structure (i.e. heat dissipating structure).

### Background of the Invention

Because of its characteristics such as a theoretically long service life, low energy consumption and environment-friendly, an LED has been widely used in various fields including indication, indoor and outdoor illumination, etc. As well known, the most critical factor affecting the service life of an LED, particularly a high-power LED, is LED heat dissipating. The existing high-power LED heat dissipating structure is manufactured by sequentially connecting parts including a heat sink, an aluminum substrate, thermally conductive silicone, heat dissipating plate, etc., and the LED is connected to the aluminum substrate via the heat sink. Although such a manufacture process is simple, the resultant heat dissipating structure as manufactured is defective and disadvantageous for poor heat conduction and dissipation performance mainly caused by structural arrangement of the aluminum substrate, thereby greatly influencing the application field and scope of the LED. Commonly, the aluminum substrate is made by stacking a protecting oil layer, a copper foil layer, an electrically insulating layer and an aluminum plate layer in sequence, among which the electrically insulating layer leads to a negative effect of heat insulation despite of its good and effective role in electrical insulation, so that the heat generated by the LED cannot be promptly dissipated, thereby greatly influencing the service life of the LED. Thus, it is necessary to improve the existing manufacturing process to realize differentiation in heat dissipating structures, and resolve the LED heat dissipating problem effectively.

### Summary of the Invention

In view of the defects and disadvantages in the prior art, an objective of the invention is to provide a manufacturing process of a high-power LED radiating structure, which is simple and of a high production efficiency, and the heat dissipating structure manufactured by the process is advantageous for a simple and compact structure, a good heat dissipating effect, etc.

The present invention employs the following technical solution, in order to achieve the above mentioned objective.

The manufacturing process of a high-power LED radiating structure of the invention includes Steps (1)-(5) below.

(1) preparing a PCB board, a heat conducting plate which is provided with a heat conducting pole on its one side and a heat dissipating plate;

(2) providing in the PCB board a locating hole passing through both sides of the PCB board, welding a copper plate layer on one side of the PCB board, and welding an electrode weld pad on the other side of the PCB board, and then applying soldering paste on the surface of the copper plate layer;

(3) inserting the heat conducting pole into the locating hole from one side of the PCB board which is provided with the copper plate layer, welding the copper plate layer and the heat conducting plate through reflow soldering, and integrally and fixedly connecting the heat conducting plate and the PCB board; where the height of the heat conduction pole is equal to or larger than the sum of thicknesses of the copper plate layer, the PCB board and the electrode weld pad;

(4) placing the assembled heat conducting plate and the PCB board obtained in Step (3) on a stamping equipment, which stamps on the upper end of the heat conducting pole, and adjusting the height of the heat conducting pole by modulating a sliding block of the stamping equipment, so that the upper end face of the heat conducting pole is at the same plane with the upper surface of the electrode weld pad; and

(5) fixedly engaging the upper side of the heat dissipating plate with the other side of the heat conducting plate.

In Step (5), several heat dissipating fins are provided on the lower side face of the heat dissipating plate.

In Step (1), the heat conducting pole and the heat conducting plate are made integrally. Alternatively, in Step (1), the heat conducting pole and the heat conducting plate are separate and fixedly welded together.

In Step (1), the heat conducting pole is threadedly connected with the locating hole.

In Step (1), the heat conducting plate is made from copper.

In Step (1), the heat dissipating plate is made from aluminum or copper.

In Step (1), the heat conducting pole is made from copper.

The above mentioned manufacturing process of the invention is beneficial as follows: since the upper surface of the electrode weld pad and the upper end face of the heat conducting pole are arranged in the same plane with the inventive process, when the bottom side of the LED substrate rests against on the electrode weld pad and the heat conducting pole, the bottom side of the LED substrate may be sufficiently in contact and welded with the upper end face of the heat conducting pole without affecting the electric connection between the bottom side of the LED substrate and the electrode weld pad, so as to effectively increase the contact area between the heat conductive part at the bottom side of the LED substrate and the upper end face of the heat conducting pole. As such, with the heat dissipating structure manufactured by the process of the invention, the heat generated by the LED can be quickly dissipated via the heat conducting pole and the heat conducting plate, thereby greatly improved the heat dissipating function of such structure.

### Brief Description of the Drawings

FIG. 1 schematically shows an overall structural section view of a heat dissipating structure manufactured according to the invention; and

FIG. 2 schematically shows an exploded structural view of the heat dissipating structure manufactured according to the invention.

### Reference numeral list:

1: LED;
2: substrate;
3: electrode weld pad;
4: PCB board
5: copper plate layer;
6: heat conducting plate;
7: locating hole;
8: heat conducting pole;
9: heat dissipating plate;
10: heat dissipating fins;

### Detailed Description of the Embodiments

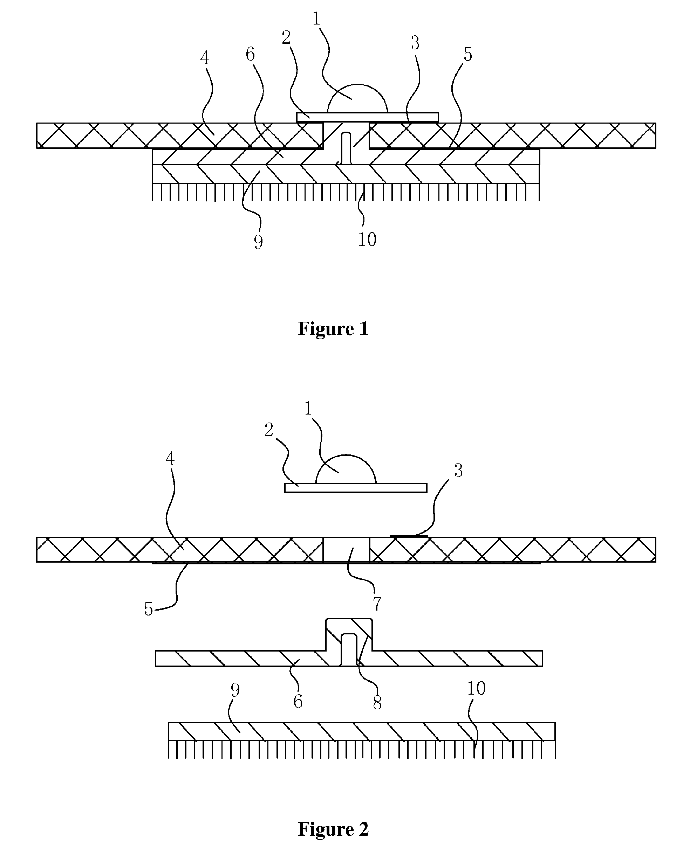

FIGs. 1-2 schematically show an overall view and an exploded view of the heat dissipating structure manufactured according to the invention, respectively.

The manufacturing process of a high-power LED radiating structure of the invention includes Steps (1)-(5) below.

At Step (1), parts or materials such as a Printed Circuit Board (PCB) board 4, a heat conducting plate 6 provided with a heat conducting pole 8 on its one side and a heat dissipating plate 9 are prepared, where the heat conducting plate 6 may be made from copper, aluminum and the like, the heat conducting pole 8 may be made from copper, and the heat dissipating plate 9 may be made from aluminum or copper. Due to the good heat conducting and dissipating function of the materials such as copper and aluminum, the achievement of the objective of the invention may be facilitated in the case that the heat conducting plate 6 and heat dissipating plate 9 are made from copper and aluminum. Of course, the aforementioned structural parts may also be made from other metal material with good heat conducting and dissipating property. The heat conducting pole 8 and the heat conducting plate 6 may be made integrally, or may be separate and welded fixedly.

At Step (2), a locating hole 7 passing through both sides of the PCB board 4 is arranged in the PCT board 4, a copper plate layer 5 is welded on one side of the PCB board 4, soldering paste is applied on the surface of the copper plate layer 5 for the purpose of fixedly welding the heat conducting plate 6; and an electrode weld pad 3 is welded on the other side of the PCB board 4 in order for connecting the electrode part at the bottom side of the substrate 2 of the LED 1.

At Step (3), the heat conducting pole 8 is inserted into the locating hole 7 from the side of the PCB board 4 which is provided with the copper plate layer 5, the copper plate layer 5 and the heat conducting plate 6 are welded through reflow soldering, and the heat conducting plate 6 and the PCB board 4 are integrally and fixedly connected. The shape and size of the heat conducting pole 8 match with shape and size of the locating hole 7, particularly, the cross section of the heat dissipating pole 8 may be of a circular, oval, triangular or hexagonal shape; when the cross section of the heat conducting pole 8 is of a circular shape, inner screw threads are provided on the inner wall of the locating hole 7, and outer screw threads are provided on the outer wall of the heat conducting pole 8, so that the heat conducting pole 8 and the locating hole 7 may be threadedly connected. The threaded connection between the heat conducting pole 8 and the locating hole 7 may improve the structural compactness of the inventive structure, thereby improving the heat conducting and dissipating function indirectly. Additionally, the height of the heat conduction pole 8 is equal to or larger than the sum of thicknesses of the copper plate layer 5, the PCB board 4 and the electrode weld pad 3.

At Step (4), the assembled heat conducting plate 6 and the PCB board 4 obtained in Step (3) is placed on a stamping equipment, which stamps on the upper end face of the heat conducting pole 8, and the height of the heat conducting pole 8 may be adjusted by modulating a sliding block of the stamping equipment, so that the upper end face of the heat conducting pole 8 is at the same plane with the upper surface of the electrode weld pad 3. This Step (4) is essential for the manufacturing process of the invention, as mentioned above, the height of the heat conduction pole 8 is equal to or larger than the sum of thicknesses of the copper plate layer 5, the PCB board 4 and the electrode weld pad 3. When the height of the heat conduction pole 8 is equal to the sum of thicknesses of the copper plate layer 5, the PCB board 4 and the electrode weld pad 3, the stamping equipment can be used to adjust the upper end face of the heat conducting pole 8 effectively, to ensure that the upper end face of the heat conducting pole 8 is at the same plane with the upper surface of the electrode weld pad 3; and when the height of the heat conduction pole 8 is larger than the sum of thicknesses of the copper plate layer 5, the PCB board 4 and the electrode weld pad 3, the sliding block of the stamping equipment is adjusted and the stamping equipment is used to stamp the heat conducting pole 8, and hence both the height and the upper end face of the heat conducting pole 8 are stamp and adjusted effectively, so that the upper end face of the heat conducting pole 8 is at the same plane with the upper surface of the electrode weld pad 3. As such, the bottom side of the substrate 2 is sufficiently engaged with both the upper end face of the heat conducting pole 8 and the upper surface of the electrode weld pad 3. That is, the electrode part at the bottom side of the substrate 2 is sufficiently in contact and welded with the electrode weld pad 3, at the same time, the heat conducting part at the bottom side of the substrate 2 is sufficiently in contact and welded with the upper end face of the heat conducting pole 8, thereby increasing the contact area between the heat conducting part at the bottom side of the substrate 2 and the upper end face of the heat conducting pole 8, to ensure that the heat generated by the LED 1 can be rapidly conducted to the heat dissipating plate 9 in time via the heat conducting pole 8 and the heat conducting plate 6, and then dissipated by the heat dissipating plate 9.

At Step (5), the upper side of the heat dissipating plate 9 is engaged with the other side of the heat dissipating plate 6, so that the heat dissipating plate 9 may be used for rapid heat dissipating from the conducting plate 6. Several dissipating fins 10 are provided on the lower side face of the heat dissipating plate 9 to increase the heat dissipating area of the dissipating plate 9, and hence to enhance the dissipating effect of the heat radiating plate 9.

The heat dissipating structure manufactured according to the invention can quickly dissipate the heat produced by the LED, and its heat conducting and dissipating effects are greatly enhanced compared with that in the prior art.

**Table 1: Temperature data measurements of the existing heat dissipating structure (former) and the inventive heat dissipating structure (new).**

| | Input current | Ambient temperature | Heat sink temperature (former) | Aluminum substrate (former) | Heat dissipating plate |
|---|---|---|---|---|---|
| | | | Heat conducting pole temperature (new) | Heat conducting plate (new) | |
| Heat dissipating structure (former) | 700mA | 24.3°C | 57.3°C | 44.7 °C | 45.2 °C |
| Heat dissipating structure (new) | 700mA | 28°C | 48.1/51 °C | 47.3/50.3 °C | 45.6/50.3 °C |

As can be seen from the above table, in the case that the high-power LEDs respectively provided with the new inventive heat dissipating structure and the former heat dissipating structure are provided with the same current, and the ambient temperature of the new heat dissipating structure is higher, the temperature of the heat conducting pole in the new heat dissipating structure is notably lower than the temperature of the heat sink of the former heat dissipating structure, but the temperature of the heat conducting plate and the heat dissipating plate in the new heat dissipating structure are notably higher than the temperature of the aluminum substrate and the heat dissipating plate of the former heat dissipating structure, this fully illustrates that the heat dissipating effect of the new heat dissipating structure made by the inventive manufacturing process is better than that of the former heat dissipating structure.

The above description discloses only preferred embodiments of the invention, and any equivalent changes and modifications made on the construction, characteristics, and principles according to the scope of the invention fall within the scope of the invention.

## Claims

1. A manufacturing process of a high-power LED heat dissipating structure, comprising steps of:
1) preparing a PCB board (4), a heat conducting plate (6) which is provided with a heat conducting pole (8) on its one side and a heat dissipating plate (9);
2) providing in the PCB board (4) a locating hole (7) that passes through both sides of the PCT board (4), welding a copper plate layer (5) on one side of the PCB board (4), and welding an electrode weld pad (3) on the other side of the PCB board (4), and then applying soldering paste on a surface of the copper plate layer (5);
3) inserting the heat conducting pole (8) into the locating hole (7) from one side of the PCB board (4) which is provided with the copper plate layer (5), welding the copper plate layer (5) and the heat conducting plate (6) through reflow soldering, and integrally and fixedly connecting the heat conducting plate (6) and the PCB board (4); wherein the height of the heat conduction pole (8) is equal to or larger than the sum of thicknesses of the copper plate layer (5), the PCB board (4) and the electrode weld pad (3);
4) placing the assembled heat conducting plate (6) and the PCB board (4) obtained in step 3) on a stamping equipment, which stamps on an upper end face of the heat conducting pole (8), and adjusting the height of the heat conducting pole (8) by modulating a sliding block of the stamping equipment, so that the upper end face of the heat conducting pole (8) is at the same plane with an upper surface of the electrode weld pad (3); and
5) fixedly engaging the upper side of the heat dissipating plate (9) with the other side of the heat conducting plate (6).

2. The process of claim 1, wherein, several heat dissipating fins (10) are provided on the lower side face of the heat dissipating plate (9) in step 5) .

3. The process of claim 1, wherein in step 1), the heat conducting pole (8) and the heat conducting plate (6) are made integrally.

4. The process of claim 1, wherein in step 1), the heat conducting pole (8) and the heat conducting plate (6) are separate and welded fixedly together.

5. The process of claim 1, wherein in step 1), the heat conducting pole (8) and the locating hole (7) are threadedly connected.

6. The process of claim 1, wherein in step 1), the heat conducting plate (6) is made from copper.

7. The process of claim 1, wherein in step 1), the heat dissipating plate (9) is made from aluminum or copper.

8. The process of claim 1, wherein in step 1), the heat conducting pole (8) is made from copper.
